**Europäisches Patentamt**

**European Patent Office**

**Office européen des brevets**

(19)

(11) Numéro de publication : **0 139 804 B1**

(12)

# FASCICULE DE BREVET EUROPÉEN

(45) Date de publication du fascicule du brevet : **15.06.88**

(51) Int. Cl.⁴ : **G 11 C 11/40, H 03 K 3/288**

(21) Numéro de dépôt : **83430036.0**

(22) Date de dépôt : **28.10.83**

(54) **Dispositif permettant l'emmagasinage d'un bit d'information et sa lecture.**

(43) Date de publication de la demande :
**08.05.85 Bulletin 85/19**

(45) Mention de la délivrance du brevet :
**15.06.88 Bulletin 88/24**

(84) Etats contractants désignés :
**DE FR GB**

(56) Documents cités :
**US-A- 3 504 350**
**US-A- 4 104 719**
**IBM TECHNICAL DISCLOSURE BULLETIN, vol. 21, no. 7, décembre 1978, New York (US) J.F. JOUDINAUD et al.:"Latch T2L circuit", pages 2866-2867**
**IBM TECHNICAL DISCLOSURE BULLETIN, vol. 25, no. 3A, août 1982, New York (US) H.O. ASKIN et al.:"Glitchless latch with extendable ports to L1 stage", pages 1026-1027**

(73) Titulaire : **International Business Machines Corporation**
**Old Orchard Road**
**Armonk, N.Y. 10504 (US)**
**DE GB**
**Compagnie IBM FRANCE**
**5 Place Vendôme**
**F-75000 Paris 1er (FR)**
**FR**

(72) Inventeur : **Beranger, Hervé**
**13 Rue Barbier**
**F-77300 Fontainebleau (FR)**
Inventeur : **Brunin, Armand**
**61 Allée de Bretagne**
**F-77350 Le Mee / Seine (FR)**
Inventeur : **Rousseau, Jean-Paul**
**1 Rue de l'Eglise Saint Germain / Ecole**
**F-77930 Perthes (FR)**

(74) Mandataire : **Lattard, Nicole**
**Compagnie IBM France Département de Propriété Intellectuelle**
**F-06610 La Gaude (FR)**

## Description

### Domaine technique

La présente invention concerne un dispositif de mémoire comportant une bascule simplifiée et des circuits d'écriture, de lecture et de sortie, particulièrement bien adaptée à la réalisation de mémoires à accès aléatoire de faible capacité et rapides.

### Etat de la Technique

Actuellement les mémoires à accès aléatoire sont généralement réalisées à partir de cellules type HARPER ou leur dérivées cellules HARPER à transistors PNP supplémentaires. L'organisation classique de ces mémoires n'est pas appropriée pour la réalisation de mémoire de faible capacité, car compte tenu de la dimension des cellules et des circuits périphériques, la surface moyenne qu'occupe un bit sur le bloc semi-conducteur est trop élevée. De plus dans ces mémoires les tensions d'alimentation sont relativement élevées (3.4 Volts minimum) et il en résulte une dissipation de puissance trop importante.

L'article paru dans l'IBM Technical Disclosure Bulletin, Vol. 25 No. 3A Août 1982 à la page 1026, décrit un circuit comportant deux bascules L1, L2, constituées de transistors couplés en croix et des circuits d'écriture de données particuliers, destiné à constituer un étage de registre à décalage.

L'article paru dans l'IBM Technical Disclosure Bulletin Vol. 21 No. 7 Décembre 1978 page 2866 décrit une bascule du type comprenant deux transistors couplés en croix, présentant la possibilité d'avoir plusieurs circuits d'entrée de données.

Le brevet US-A 3504 350 décrit un arrangement matriciel de cellules de mémoire avec des circuits d'écriture et de lecture particuliers.

Le brevet US-A 4104 719 décrit un arrangement de mémoire permettant un accès simultané à plusieurs mots.

### Résumé de l'Invention

Un objet de la présente invention est donc de réaliser un dispositif comportant une bascule d'emmagasinage simplifiée et des circuits d'écriture, de lecture et de sortie peu encombrants permettant de constituer une mémoire à accès aléatoire, dans laquelle les tensions d'alimentation sont faibles.

La bascule destinée à l'emmagasinage d'un bit d'information comprend essentiellement trois transistors. Chaque transistor a une électrode de commande, (la base) et deux électrodes de conduction (émetteur et collecteur). Dans un mode de réalisation préféré ces transistors sont du type NPN, mais il est évident que ces transistors peuvent être remplacés par des transistors PNP.

Un bit est emmagasiné dans la bascule sous contrôle d'un circuit de commande d'écriture comprenant un premier circuit ET (D1, D2), recevant sur une première entrée le bit à emmagasiner et sur une seconde entrée un signal de commande d'écriture. La bascule comprend un premier transistor (T1) d'entrée dont l'électrode de commande est connectée à la sortie du circuit ET, une première électrode de conduction est connectée à un premier potentiel d'alimentation (V⁺) par une première résistance (R2) et la seconde électrode de conduction est connectée à un potentiel de référence (V_{REF}) de sorte que l'état dudit transistor est commandé par le signal de sortie du circuit ET. Un second transistor (T2) reçoit sur sa première électrode de conduction le signal de commande d'écriture. Un troisième transistor (T3) a son électrode de commande connectée à la seconde électrode de conduction du second transistor et à la première électrode de conduction du premier transistor, une première électrode de conduction reliée à un second potentiel d'alimentation (V⁻) et la seconde électrode de conduction reliée par un circuit de décalage de niveau à l'électrode de commande du second transistor d'une part, et au premier potentiel d'alimentation d'autre part par une seconde résistance R3, de telle sorte que le potentiel à la seconde électrode de conduction dudit transistor représente le bit emmagasiné dans la bascule.

La lecture du bit emmagasiné dans la cellule est effectuée par l'intermédiaire d'un circuit de commande de lecture comprenant un circuit ET (D4, D5) ayant une première entrée connectée à la seconde électrode de conduction du troisième transistor et une seconde entrée recevant un signal de commande de lecture et d'un transistor émetteur suiveur de sortie (T4) ayant son électrode de commande reliée à la sortie dudit circuit ET, la première électrode de conduction connectée au premier potentiel d'alimentation et la seconde électrode de conduction connectée à un circuit de sortie de lecture.

Le circuit de sortie comprend :

un quatrième transistor (T5) ayant une première électrode de conduction (collecteur) connectée au premier potentiel d'alimentation par une troisième résistance (R5) et la seconde électrode de conduction (émetteur) connectée à la seconde électrode de conduction (émetteur) du transistor émetteur-suiveur (T4), d'une part et au second potentiel par une quatrième résistance (R9),

un cinquième transistor (T6) ayant son électrode de commande connectée à l'électrode de commande du quatrième transistor (T5) et au premier potentiel d'alimentation par une cinquième résistance (R6), sa première électrode de conduction (collecteur) connectée au premier potentiel d'alimentation par une sixième résistance (R8) et sa seconde électrode de conduction connectée par une septième résistance (R10) au second potentiel d'alimentation, la valeur de cette septième résistance étant supérieure à la valeur de la quatrième résistance,

une première diode (S5) montée entre l'électrode de commande et la première électrode de conduction, du quatrième transistor,

une deuxième diode (S6) montée entre l'électrode de commande et la première électrode de conduction du cinquième transistor de façon que l'un ou l'autre des quatrième et cinquième transistors soit rendu conducteur suivant l'état du transistor émetteur suiveur de sortie de la bascule,

un sixième transistor de sortie (T7) ayant sa première électrode de conduction (collecteur) connectée au premier potentiel d'alimentation par une huitième résistance, sa seconde électrode de conduction connectée au second potentiel d'alimentation (V⁻) et son électrode de commande connectée à la première électrode de conduction du quatrième transistor, pour fournir sur la première électrode de conduction un signal de sortie dont la valeur est le complément de la valeur du bit emmagasiné dans la cellule.

Ce dispositif peut être utilisé comme dispositif d'emmagasinage dans une mémoire à accès aléatoire, comportant une matrice de cellules. Les bascules de chaque rangée ont la seconde entrée du circuit ET de commande d'écriture connecté à une ligne de commande d'écriture pour recevoir lorsque la rangée est sélectionnée le signal de commande d'écriture provoquant l'emmagasinage dans chacune des bascules de la rangée du bit appliqué à la première entrée des circuits ET des bascules.

Les bascules de chaque rangée ont la seconde entrée du circuit ET de commande de lecture connectée à une ligne de commande de lecture pour recevoir lorsque la rangée est sélectionnée, le signal de commande de lecture, et l'émetteur du transistor émetteur suiveur de sortie est relié à une ligne de bit connectée au circuit de sortie de lecture.

Une telle structure peut être adaptée en ajoutant à la bascule au moins un transistor d'entrée et au moins un transistor émetteur suiveur, à la conception d'une mémoire à accès aléatoire dans laquelle au moins deux rangées peuvent être écrites simultanément et au moins deux autres rangées peuvent être lues simultanément.

Brève Description des Figures

La Figure 1 représente la bascule simplifiée et un circuit de sortie, pouvant être utilisée dans une mémoire à accès aléatoire.

La Figure 2 représente l'arrangement matriciel de bascules associées à des circuits de sortie, constituant une mémoire.

La Figure 3 représente une bascule du même type que celle de la Figure 1, comportant plusieurs commandes d'écriture et de lecture.

La Figure 4 représente un circuit permettant de générer les commandes d'écriture.

La Figure 5 représente un circuit permettant de générer les commandes de lecture.

La Figure 6 représente un arrangement de plusieurs matrices de bascules et de leurs circuits associés.

Description Détaillée

La cellule de mémoire de la présente invention est constituée d'une bascule simplifiée alimentée sous une faible tension de 1,7 Volt dans un mode de réalisation préférée.

Elle comprend trois transistors T1, T2, T3 et un transistor émetteur suiveur de sortie T4 ces transistors sont de type NPN, dans un mode de réalisation préféré. Les transistors T1, T2 et T3 sont munis de diode de Schottky d'anti-saturation S1, S2 et S3 respectivement ayant l'anode connectée à la base du transistor et la cathode connectée au collecteur.

Le bit d'information à écrire dans la cellule est appliqué à la borne d'entrée IN. Deux diodes de Schottky contrôlent l'écriture. La première diode D1 a sa cathode connectée à la borne d'entrée et son anode connectée à la base du transistor T1 et la seconde D2 a son anode connectée à l'anode de la diode D1 et sa cathode connectée à l'émetteur du transistor T2 et à une ligne de commande d'écriture WRL. Ces deux diodes constituent un circuit ET qui permet l'écriture du bit 1 ou 0 appliqué à l'entrée IN, lorsque la ligne WRL est active.

Le transistor T1 a sa base et son collecteur connectés au potentiel V⁺ par les résistances R1 et R2 respectivement. Son émetteur relié à un potentiel de référence VREF.

Le collecteur du transistor T1 est connecté au collecteur du transistor T2 et la base du transistor T2 est connectée au potentiel d'alimentation V⁺ par une résistance R3.

Le transistor T3 a sa base connectée au collecteur du transistor T2, son émetteur connecté au potentiel d'alimentation V⁻ et son collecteur connecté à la cathode d'une diode de Schottky D3 dont l'anode est connectée à la base du transistor T2.

L'état de la bascule est déterminé par le niveau de tension au collecteur du transistor T3.

Le bit emmagasiné dans la cellule est lu au moyen d'un circuit de sortie. Dans l'organisation d'une mémoire constituée d'une matrice de cellules, il y a un circuit de sortie par ligne de bit BL.

La cellule de mémoire est connectée à un transistor émetteur suiveur de sortie T4. L'émetteur du transistor T4 est connecté à une ligne de bit BL. Dans un arrangement matriciel de cellules tous les transistors émetteur suiveur T4 des cellules d'une même colonne sont connectés à la même ligne de bit.

Le collecteur du transistor T4 est connecté au potentiel d'alimentation V⁺, sa base est connectée au potentiel d'alimentation V⁺ par une résistance R4, à la sortie OUT de la bascule par une diode de Schottky D4 et à la ligne de commande de lecture par une diode de Schottky D5. Les diodes de Schottky D4 et D5 sont disposées de telle façon que leurs anodes sont connectées à la base du transistor T4.

Le circuit de sortie comporte trois transistors T5, T6, et T7 avec des diodes de Schottky d'antisaturation S5, S6 et S7.

L'émetteur du transistor T5 est connecté à la ligne de bit BL et son collecteur est connecté par une résistance R5 au potentiel d'alimentation V⁺. Les bases des transistors T5 et T6 sont connectées par la résistance R6 au potentiel d'alimentation V⁺ et le collecteur du transistor T6 est connecté au potentiel V⁺ par la résistance R8. Les émetteurs des transistors T5 et T6 sont connectés au potentiel d'alimentation V⁻ par les résistances R9 et R10 respectivement.

La base du transistor T7 est connectée au collecteur du transistor T5, son émetteur est connecté au potentiel d'alimentation V⁻ et son collecteur est connecté à l'alimentation V⁺ par la résistance R7.

Le signal de sortie indiquant l'état de la cellule lue est pris au collecteur OUT du transistor T7.

Dans un mode de réalisation préféré, les transistors des cellules et des circuits de sortie sont des transistors NPN et le potentiel d'alimentation V⁺ est égal à 1,7 volt et le potentiel d'alimentation V⁻ est zéro volt. Les résistances ont les valeurs suivantes R1 = 20 k, R2 = 16,5 k, R3 = 11 k, R4 = 15 k, R5 = R8 = 11 k, R6 = 15 k, R7 = 8 k, R9 = 10 k et R10 = 2,2 k.

Un circuit de commande de lecture/écriture 1 fournit sur les lignes de commande de lecture et d'écriture RL et WRL les signaux de commande pour provoquer la lecture et l'écriture de la cellule.

On va maintenant décrire le fonctionnement de la cellule.

Au repos, la ligne d'écriture WRL est au niveau bas. Ceci permet au transistor T2 d'être conducteur si la sortie est à un niveau haut, et force le transistor T1 dans l'état bloqué, le courant circulant dans la résistance R1 passant dans la diode D2 alors conductrice.

Pour réaliser une opération d'écriture, la ligne de commande d'écriture WRL est mise au niveau haut par le circuit de commande de lecture/écriture R/W 1.

En conséquence le transistor T2 se bloque de même que la diode D2 de sorte que le courant circulant dans la résistance R1 ne peut plus passer dans cette diode.

Si le niveau sur l'entrée de bit IN est bas, la diode D1 est conductrice et le courant dans la résistance R1 passe dans cette diode, ce qui fait que le transistor T1 est bloqué. Les transistors T1 et T2 étant simultanément bloqués le courant circulant dans la résistance R2 rend conducteur le transistor T3 si bien que la sortie OUT est au niveau bas. Le courant circulant dans R3 passe dans la diode D3, en conséquence même lorsque le niveau de la ligne d'écriture redevient bas le transistor T2 ne peut pas être conducteur.

Si le niveau sur l'entrée IN est haut, le courant circulant dans la résistance R1 rend le transistor T1 conducteur. Le transistor T3 est bloqué et le transistor T2 sera conducteur lorsque le niveau de la ligne d'écriture redeviendra bas au repos.

Le rôle de la diode D3 est le suivant. Si la base du transistor T2 était connectée directement au collecteur du transistor T3 le circuit fonctionnerait plus lentement et la dissipation de puissance augmenterait.

Le circuit serait aussi plus lent car l'excursion de tension sur la base du transistor T2 serait plus grande et l'effet de la capacité parasite serait plus important. La dissipation de puissance augmenterait car lorsque le transistor T3 serait conducteur, le courant dans la résistance R3 serait plus grand du fait que la chute de tension au borne de R3 serait plus grande.

Cette diode D3 pourrait être remplacée par une résistance mais il en résulterait une augmentation des capacités parasites et de la surface. En effet, en utilisant une diode, il n'est pas nécessaire de prévoir un contact collecteur pour le transistor et un contact cathode pour les diodes D3 et D4, car ces éléments D3, D4, T3 peuvent être intégrés dans le même lit épitaxial et il n'est pas nécessaire d'avoir accès au collecteur de T3.

Afin de réduire la capacité de sortie lorsque le nombre de cellules connectées à une même ligne de bit augmente, et de ce fait ne pas augmenter le temps d'accès en lecture, on utilise un transistor émetteur suiveur T4.

A cause du faible potentiel d'alimentation V⁺ dont la valeur minimale peut être de 1,46 volt, il n'est pas possible d'attaquer une porte logique TTL classique. En conséquence, le circuit de sortie est constitué d'un amplificateur à gain élevé avec un seuil dont la valeur est adaptée à celle de la tension de référence VREF sur l'émetteur du transistor T1 de la cellule qui permet d'avoir un temps d'accès en lecture, court. Le fonctionnement du circuit de sortie sera décrit ultérieurement.

Le transistor T4 ayant son collecteur connecté directement au potentiel d'alimentation V⁺ peut être intégré dans le lit épitaxial des résistances et n'occupe donc que la surface de la jonction base-émetteur.

La lecture de la cellule est contrôlée par les deux diodes D4 et D5 constituant un circuit ET. Pour réaliser la lecture, la ligne de lecture RL est mise à un niveau haut par le circuit de commande de lecture/écriture 1. Le potentiel de la base du transistor T4 devient voisin du potentiel V⁺ si le potentiel de sortie de la bascule est haut. Si le potentiel de sortie de la bascule est au niveau bas, le courant circulant dans la résistance R4 passe dans la diode D4 ce qui maintient la ligne de bit à un niveau bas.

Lorsque le transistor T4 est bloqué (niveau bas sur la sortie OUT) aucun courant n'est appliqué au circuit de sortie (Iin = 0). Les résistances collecteur R5 et R8 des transistors T5 et T6 sont de même valeur, la résistance base est commune et les résistances émetteur R9 et R10 sont légèrement différentes pour que le courant circulant dans le transistor T5 soit supérieur au courant circulant dans le transistor T6. Il s'ensuit qu'un courant circule à travers la diode S5 et le transistor T7 est bloqué, la sortie OUT au collecteur du transistor T7 est au niveau haut.

Lorsque le transistor T4 est conducteur (niveau haut sur la sortie OUT) un courant lin est appliqué au circuit de sortie, qui a tendance à bloquer le transistor T5 du fait que son potentiel émetteur augmente. Le courant qui circulait dans la diode S5 passe dans la diode S6. Le potentiel de base du transistor T5 est essentiellement défini par les résistances R6, R10 et R8. Lorsque lin est suffisamment élevé, le transistor T5 est bloqué et le courant circulant dans la résistance R5 rend le transistor T7 conducteur, donc le niveau sur la sortie OUT est bas.

En bref, le circuit de sortie est un amplificateur différentiel comprenant les transistors T4 et T5, la base du transistor T5 étant connectée à un circuit fournissant une tension de référence et la base du transistor T4 recevant le signal d'entrée.

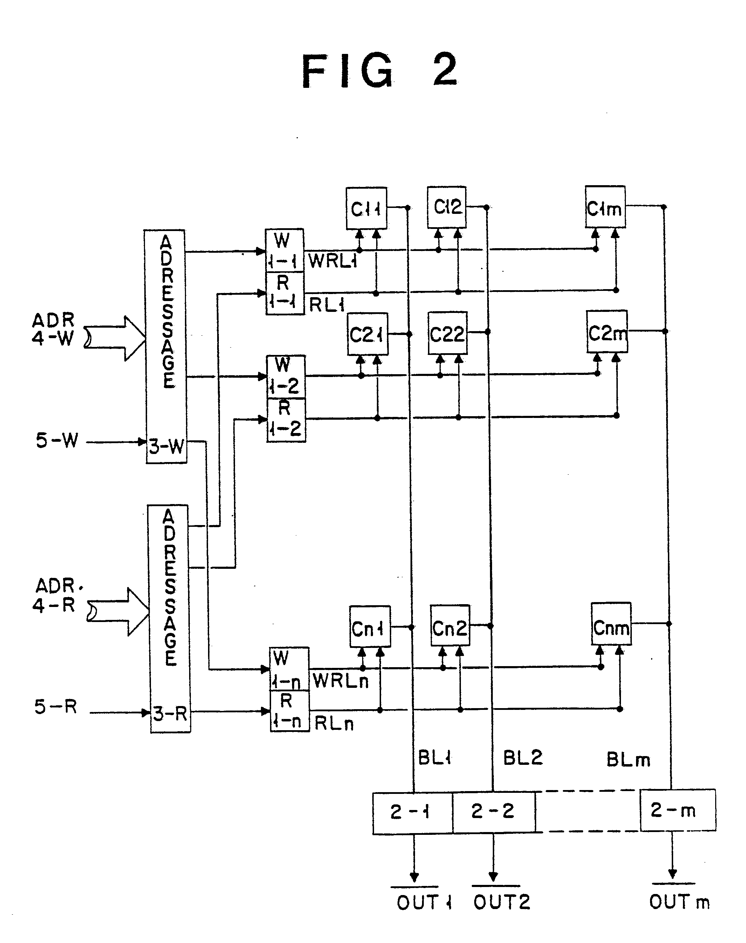

A partir de cette cellule de mémoire on peut construire une matrice de n rangées et m colonnes de cellules C i j comme schématisée sur la Figure 2.

Les cellules d'une même rangée sont sélectionnées sous commande de circuits de commande de lecture/écriture RI-I/WI-I à RI-n/WI-n qui fournissent sur les lignes d'écriture WRLI à WRLn et RLI à RLn, les signaux de sélection permettant la lecture ou l'écriture des cellules d'une rangée.

Afin de pouvoir réaliser la lecture d'une rangée en même temps que l'écriture d'une autre rangée, deux circuits d'adressage 3-W et 3-R sont prévus.

Le circuit d'adressage 3-W reçoit la configuration des bits d'adresse de la rangée à sélectionner sur les lignes 4-W et un signal de commande d'écriture sur la ligne 5-W pour provoquer l'excitation d'une des lignes WRLI à n par le circuit de commande d'écriture WI-I à WI-n associé.

Le circuit d'adressage 3-R reçoit la configuration des bits d'adresse de la rangée à sélectionner sur les lignes 4-W et un signal de commande de lecture que la ligne 5-R pour provoquer l'excitation d'une des lignes RLI à RLn par le circuit de commande de lecture RI-I à RI-n.

Les cellules d'une même colonne sont connectées aux lignes de bits BLI à BLm. Des circuits de sortie 2-I à 2-m connectés à chaque ligne de bit BLI à BLn permettent de détecter l'état des cellules de la rangée sélectionnée pour une opération de lecture. Ils fournissent les signaux OUTI à OUTn relatifs à chaque ligne de bit.

On peut réaliser à partir de l'arrangement matriciel de cellules, en ajoutant des commandes supplémentaires, une mémoire dans laquelle on peut écrire simultanément plusieurs rangées de cellules et lire plusieurs autres rangées.

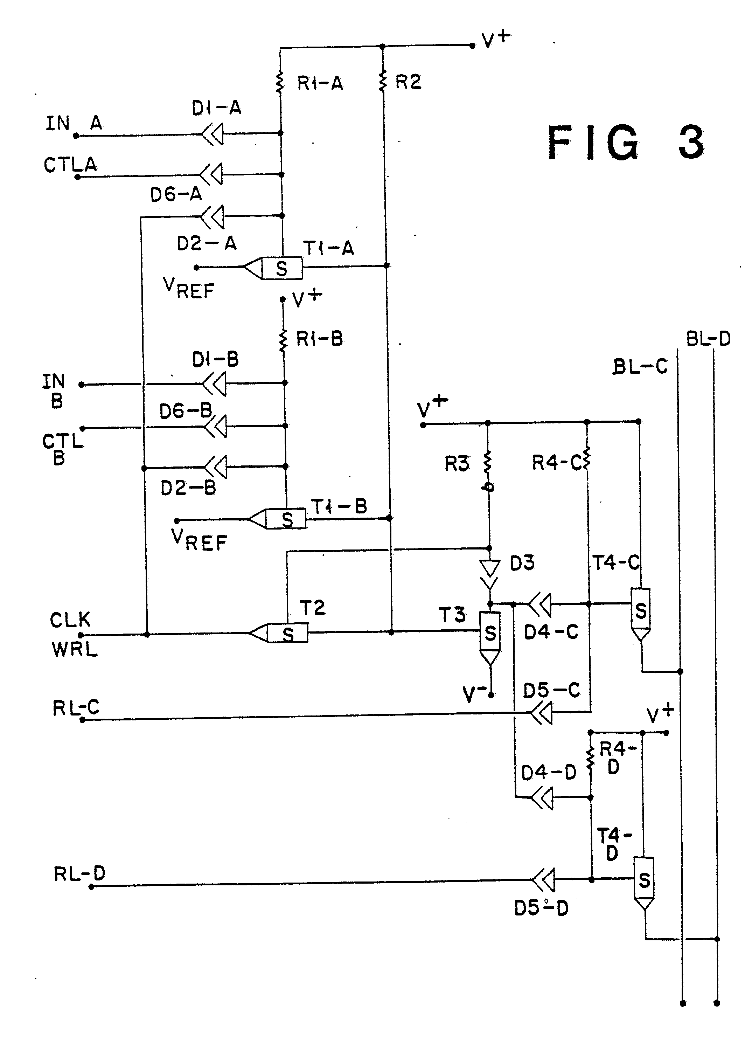

Sur la Figure 3 sont représentés les éléments supplémentaires à ajouter à une cellule pour réaliser une mémoire dans laquelle on peut écrire dans deux rangées simultanément et lire deux autres rangées.

Partant de cet arrangement, il est facile de concevoir une mémoire dans laquelle on peut lire et écrire simultanément le nombre désiré de rangées.

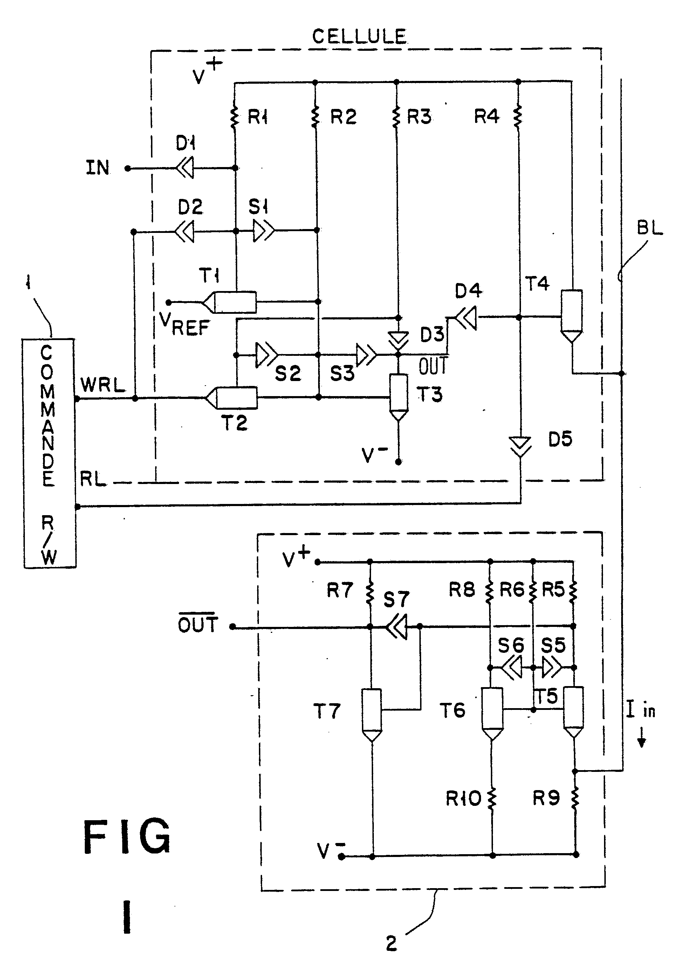

Les mêmes numéros de référence sont utilisés sur les Figures 1 et 3. Des suffixes A, B, C et D ont été ajoutés aux références des éléments supplémentaires. Le S dans chacun des transistors indique qu'une diode de Schottky d'antisaturation non représentée est associé au transistor comme sur la Figure 1.

Pour l'écriture, des cellules de deux rangées distinctes, deux transistors T1 sont prévus, T1-A et T1-B qui reçoivent les deux bits d'entrée IN A et IN B appliquées aux cathodes des diodes D1-A et D1-B.

Deux diodes de Schottky supplémentaires D6-A et D6-B ont leurs anodes connectées aux bases des transistors T1-A et T1-B et leur cathodes connectées à une entrée de commande CTL A et CTL B.

Pour réaliser une opération d'écriture dans les rangées sélectionnées, les entrées de commande d'horloge d'écriture CLK WRL de ces deux rangées sont mises au niveau haut.

Dans une des rangées, l'entrée de commande d'écriture CLT A sera mise au niveau bas et CLT B au niveau haut et dans l'autre rangée l'entrée de commande d'écriture CLT A sera mise au niveau haut et CLT B sera mise au niveau bas.

Dans la cellule dans laquelle la ligne de commande CTL A est au niveau bas, la diode D6-A est conductrice et le transistor T1-A est bloqué si bien que l'écriture du bit sur l'entrée IN A ne peut être effectuée. Dans cette même cellule la ligne de commande CTL B est au niveau haut, la diode D6 B est bloquée et l'écriture du bit sur l'entrée IN B est réalisée de la même façon que décrit en référence à la Figure 1 par le transistor T1-B et la diode D1-B qui joue le même rôle que le transistor T1 et la diode D1.

Pour la lecture simultanée de deux rangées, deux lignes de bits BL-C et BL-D sont prévues, chacune étant associée à un transistor émetteur-suiveur T4-C et T4-D jouant le même rôle que le transistor T4 de la Figure 1.

Deux commandes de lecture RL-C et RL-D appliquées sur les cathodes D5-C et D5-D permettent de lire deux rangées de cellules simultanément.

Les diodes D4-C et D4-D et les résistances R4-C et R4-D jouent le même rôle que la diode D4 et la résistance R4 de la Figure 1 pour chacun des transistors T4-C et T4-D.

En conséquence si la commande sur la ligne RL-C est au niveau haut et celle sur la ligne RL-D est au niveau bas, la diode D5-C est bloquée et D5-D est conductrice si bien que le transistor T4-D est bloqué et la lecture sera effectuée par le circuit D4-C, T4-C et la ligne de bit BL-C de la même façon que décrit en référence à la Figure 1.

Dans le cas où la commande sur RL-C est au niveau bas et celle sur RL-D est au niveau haut et la lecture est effectuée par le circuit D4-D, T4-D et la ligne de bit BL-D.

A chacune des lignes de bits est associé un circuit de sortie 2 identique à celui de la Figure 1.

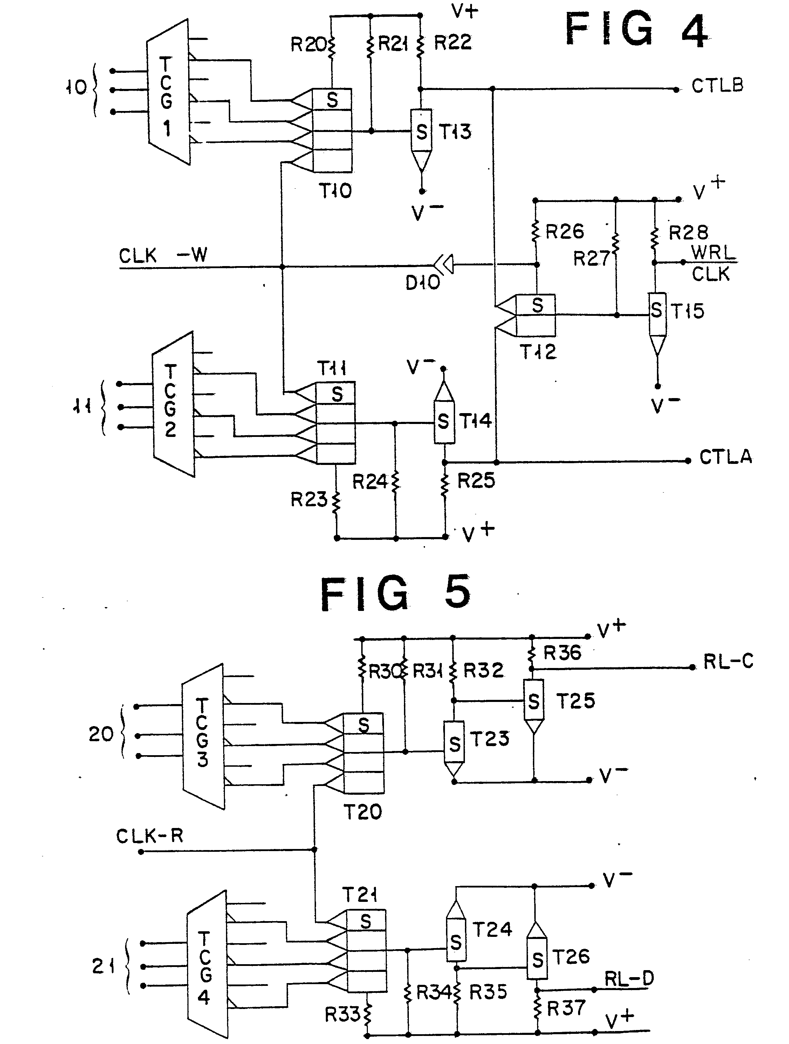

Sur la Figure 4, est représenté le circuit de commande pour générer les signaux de commande sur les lignes CTL A, CTL B et WRL CLK.

Dans la représentation de la Figure 4, il a été supposé à titre d'exemple que la mémoire comprend huit rangées pouvant être adressées par une configuration de 3 bits d'adresse.

Un premier générateur de valeur vraie/complément TCG 1 reçoit sur son entrée 10 les bits d'adresse d'une des rangées à sélectionner et un second générateur de valeur vraie/complémentaire TCG 2 reçoit sur son entrée 11 les bits d'adresse de l'autre rangée à sélectionner.

Les générateurs fournissent sur leurs lignes de sortie, la valeur vraie et le complément des bits d'adresse d'entrée, le complément étant fourni sur la ligne marquée du signe.

A chacune des rangées de la mémoire sont associés trois circuits de commande comprenant les trois transistors multi-émetteurs T10, T11, T12. On a représenté les circuits de commande associé à la rangée d'adresse 000.

Les transistors T10 et T11 ont trois de leurs émetteurs connectés aux sorties des générateurs TGC1 et TGC2 qui sont toutes à 1 quand la rangée correspondante est adressée, dans le cas de la rangée 000, les émetteurs sont connectés aux sorties complémentaires. Le quatrième émetteur reçoit un signal d'horloge d'écriture CLK-W.

Les bases des transistors T10 et T11 sont connectées au potentiel d'alimentation V⁺ par les résistances R20 et R23 respectivement. Leurs collecteurs sont connectés à ce même potentiel par les résistances R21 et R24 et aux bases des transistors T13 et T14. Les collecteurs des transistors T13 et T14 sont connectés au potentiel V⁺ par les résistances R22 et R25, et leurs émetteurs sont connectés au potentiel V⁻. Les signaux de commande CTL B et CTL A sont pris aux collecteurs des transistors T13 et T14.

Les émetteurs du transistor T12 sont connectés aux collecteurs des transistors T13 et T14, la base est connectée au potentiel V⁺ par la résistance R26, son collecteur est connecté à ce même potentiel par la résistance R27. Il est aussi connecté à la base du transistor T15. Le collecteur du transistor T15 est connecté au potentiel V⁺ par la résistance R28 et son émetteur connecté au potentiel V⁻. Le signal de commande WRL CLK est pris au collecteur du transistor T15. Le signal d'horloge CLK-W est appliqué à la base du transistor T12 par la diode de Schottky D10.

Le fonctionnement du circuit est le suivant :

En supposant que la rangée 000 soit la première rangée à adresser pour une opération d'écriture, la configuration d'adresse 000 sera appliquée à l'entrée du générateur TGC1, la configuration d'adresse de l'autre rangée à sélectionner par exemple 001 étant appliquée à l'entrée de l'autre générateur TGC2. Le signal d'horloge d'écriture CLK-W est au niveau haut.

Les émetteurs du transistor T10 seront tous au niveau haut, et au moins un des émetteurs du transistor T11 sera au niveau bas. En conséquence le transistor T10 est bloqué et le transistor T11 est conducteur.

Le transistor T13 est conducteur donc le niveau sur la ligne CTL B est bas et le transistor T14 est bas et le niveau sur la ligne CTL A est haut.

Le transistor T12 est conducteur, et le transistor T15 est bloqué, le signal sur la ligne WRL CLK est haut.

La fonction de la diode D10 est de remettre en forme le front avant de l'impulsion d'horloge d'écriture CLK-W.

Ainsi les lignes CTL A, B et WRL CLK sont aux niveaux appropriés pour provoquer l'écriture dans les cellules de la rangée sélectionnée (000) des bits de données sur les entrées IN A.

Dans les cellules de l'autre rangée sélectionnée (001), le transistor T11 sera bloqué et le transistor T10 sera conducteur, de telle sorte que les niveaux des lignes CTL B et CTL A, WRL CLK provoqueront l'écriture dans les cellules de cette rangée des bits sur les entrées IN B.

Dans toutes les autres rangées, les transistors T10 et T11 sont conducteurs et les niveaux sur les lignes CTL B, CTL A sont hauts. Le transistor T12 est donc bloqué et le transistor T15 est conducteur si bien que le niveau sur la ligne WRL CLK est bas. Aucune opération d'écriture n'est possible.

Lorsque par erreur, la même configuration de bits d'adresse est appliquée aux deux générateurs TCG1 et TCG2, les deux lignes CTL A et CTL B sont au niveau bas ce qui fait qu'un zéro est écrit dans toutes les cellules de la rangée ayant cette adresse.

La commande de lecture est plus simple du fait qu'elle ne nécessite pas de ligne WRL CLK. Un schéma du circuit de commande de lecture d'une rangée (par exemple 000) est représenté sur la Figure 5.

Pour la lecture deux autres générateurs de valeur vraie/complémentaire TCG3 et TCG4 reçoivent sur leurs entrées 20 et 21 les configurations des bits d'adresse des rangées à sélectionner. Un signal d'horloge de commande de lecture CLK-R est mis au niveau haut pour réaliser une opération de lecture de rangées sélectionnées.

Pour chaque rangée, deux transistors multi-émetteurs T20 et T21 ont trois de leurs émetteurs connectés aux sorties des générateurs TCG3 et TCG4, le quatrième émetteur recevant le signal d'horloge CLK-R. Les collecteurs des transistors T21 et T22 sont connectés aux bases des transistors T23 et T24 disposés comme les transistors T13 et T14 de la Figure 4.

Des transistors inverseurs T25 et T26 ont leurs bases connectées aux collecteurs des transistors T23 et T24, leurs collecteurs connectés au potentiel V⁺ par les résistances R36 et R37 et leurs émetteurs connectés au potentiel V⁻.

Les résistances R30 à R35 sont disposées de la même façon que les résistances R20 à R25 de la Figure 4 par rapport aux transistors T20, T21, T23 et T24.

Les signaux de commande RL-C et RL-D sont pris aux collecteurs des transistors T25 et T26 respectivement.

Lorsque le signal d'horloge de lecture est haut, suivant les configurations d'adresses sur les entrées des générateurs TCG3 et TCG4, les signaux RL-C et RL-D seront aux niveaux appropriés pour provoquer la lecture d'une première rangée et d'une seconde rangée.

Par exemple, si la configuration d'adresse 000 est appliquée au générateur TCG3 et 001 est appliquée au générateur TCG4, le signal RL-C pour la rangée 000 sera haut provoquant la lecture des cellules de cette rangée le signal RL-D pour cette rangée étant bas.

Le signal RL-C pour la rangée 001 sera bas et le signal RL-D sera haut provoquant la lecture des cellules de cette seconde rangée.

Dans toutes les autres rangées, les signaux RL-C et RL-D sont bas du fait que les transistors T20 et T21 dans les circuits de commande de lecture de ces rangées, sont conducteurs.

Ce même type de circuit peut être utilisé pour générer les signaux de commande WRL et RL d'une mémoire constituée des cellules de la Figure 1. Dans ce cas, un des générateurs TCG3 par exemple, reçoit les bits d'adresse de la rangée à sélectionner pour l'écriture et l'autre reçoit les bits d'adresse de la rangée à sélectionner pour la lecture.

A chaque rangée correspondent des transistors T20, T23, T25 et T21, T24, T26 arrangés comme sur la Figure 5.

L'émetteur du transistor T20 non connecté au générateur TCG3 reçoit le signal d'horloge d'écriture CLK-W et l'émetteur du transistor T21 non connecté au générateur TCG4 reçoit le signal d'horloge de lecture CLK-R. Les signaux de commande d'écriture WRL et de la commande de lecture RL sont obtenus sur les collecteurs des transistors T25 et T26.

Dans un tel ensemble de mémoire, le temps d'accès en lecture est d'environ 7 ns. Les lignes d'écriture doivent être excitées pour une opération d'écriture pendant 7 ns au plus. Les bits d'entrée doivent être maintenus au moins 7 ns après la transition arrière des impulsions provoquant l'écriture.

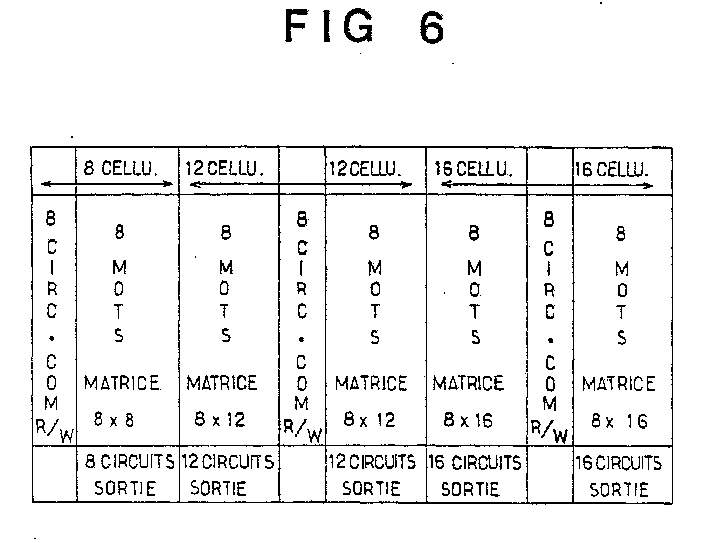

La Figure 6 montre un arrangement de cellules avec leurs circuits de commande de lecture/écriture, R/W constituant une mémoire comprenant trois ensembles de 8 × 8 cellules, 24 × 8 cellules et 32 × 8 cellules. Un tel arrangement occupe une surface de 4,88 mm².

**Revendications**

1. Dispositif permettant l'emmagasinage d'un bit d'information et sa lecture comprenant un circuit de commande d'écriture (D1, D2) sensible au niveau du bit (IN) à emmagasiner et à un signal de commande d'écriture (WRL) et une bascule du type comprenant un premier transistor d'entrée (T1) dont l'électrode de commande (base) est connectée à la sortie du circuit de commande d'écriture, une première électrode de conduction (collecteur) est connectée à un premier potentiel d'alimentation (V⁺) par une première résistance (R2) et la seconde électrode de conduction (émetteur) est connectée à un potentiel de référence (V_REF) de sorte que l'état dudit transistor est commandé par le signal de sortie du circuit de commande d'écriture, un second transistor (T2) dont une première électrode de conduction (émetteur) reçoit le signal de commande d'écriture, et un troisième transistor (T3) ayant son électrode de commande (base) reliée à la seconde électrode de conduction (collecteur) du second transistor d'une part et à la première électrode de conduction (collecteur) du premier transistor (T1) d'autre part, une première électrode de conduction (émetteur) reliée à un second potentiel d'alimentation (V⁻), et la seconde électrode de conduction (collecteur) reliée par un circuit de décalage de niveau (D3) à l'électrode de commande du second transistor d'une part et au premier potentiel d'alimentation par une seconde résistance (R3), d'autre part, de telle sorte que le potentiel à la seconde électrode de conduction représente le bit emmagasiné dans la bascule, ledit dispositif étant caractérisé en ce qu'il comprend :

un circuit de commande de lecture comprenant un circuit ET à deux entrées (D4, D5), ayant une première entrée connectée à la seconde électrode de conduction du troisième transistor, et la seconde entrée recevant un signal de commande de lecture (RL),

un transistor émetteur suiveur de sortie (T4) ayant son électrode de commande reliée à la sortie du circuit ET, la première électrode de conduction (collecteur) connectée au premier potentiel d'alimentation (V⁺) et la seconde électrode de conduction (émetteur) connectée à un circuit de sortie de lecture (2), qui comprend :

un quatrième transistor (T5) ayant une première électrode de conduction (collecteur) connectée au premier potentiel d'alimentation par une troisième résistance (R5) et la seconde électrode de conduction (émetteur) connectée à la seconde électrode de conduction (émetteur) du transistor émetteur-suiveur (T4), d'une part et au second potentiel par une quatrième résistance (R9) d'autre part,

un cinquième transistor (T6) ayant son électrode de commande connectée à l'électrode de commande du quatrième transistor (T5) et au premier potentiel d'alimentation par une cinquième résistance (R6), sa première électrode de conduction (collecteur) connectée au premier potentiel d'alimentation par une sixième résistance (R8) et sa seconde électrode de conduction connectée par une septième résistance (R10) au second potentiel d'alimentation, la valeur de cette septième résistance étant supérieure à la valeur de la quatrième résistance,

une première diode (S5) montée entre l'électrode de commande et la première électrode de conduction, du quatrième transistor,

une deuxième diode (S6) montée entre l'électrode de commande et la première électrode de conduction du cinquième transistor de façon que l'un ou l'autre des quatrième et cinquième transistors soit rendu conducteur suivant l'état du transistor émetteur suiveur de sortie de la bascule,

un sixième transistor de sortie (T7) ayant sa première électrode de conduction (collecteur) connectée au premier potentiel d'alimentation par une huitième résistance (R7), sa seconde électrode de conduction connectée au second potentiel d'alimentation (V⁻) et son électrode de commande connectée à la première électrode de conduction du quatrième transistor, pour fournir sur la première électrode de conduction un signal de sortie dont la valeur est le complément de la valeur du bit emmagasiné dans la cellule.

2. Dispositif selon la revendication 1 caractérisé en ce que le circuit de commande d'écriture comprend un circuit ET à deux entrées recevant sur une première entrée le bit à emmagasiner et sur une seconde entrée le signal de commande d'écriture.

3. Mémoire à accès aléatoire caractérisé en ce qu'elle comprend une matrice de bascules et des circuits d'écriture et de lecture selon la revendication 2, dans laquelle :

. chacune des bascules dans chaque rangée a la seconde entrée du circuit ET de commande d'écriture connectée à une ligne de commande d'écriture (WRL), pour recevoir lorsque la rangée est sélectionnée, le signal de commande d'écriture provoquant l'emmagasinage dans chacune des bascules de la rangée du bit appliqué à la première entrée des circuits ET d'écriture des bascules,

. chacune des bascules dans chaque rangée a la seconde entrée du circuit ET de commande de lecture connectée à une ligne de commande de lecture (RL) pour recevoir lorsque la rangée est sélectionnée, le signal de commande de lecture, et la seconde électrode de conduction (émetteur) du transistor émetteur suiveur de sortie connectée par une ligne de bit (BL) à un circuit de sortie de lecture, commun à toutes les bascules de même ordre dans les différentes rangées.

4. Dispositif selon la revendication 1 pour l'emmagasinage d'un bit de données caractérisé en ce que le circuit de commande d'écriture comprend au-moins deux circuits ET, dont les sorties sont connectées aux électrodes de commande d'au moins deux premiers transistors d'entrées (T1-A et T1-B) dont les premières électrodes de conduction (collecteur) sont connectées ensembles, à la seconde électrode (collecteur) du second transistor, chacun desdits circuits ET ayant trois entrées, la première recevant le bit à emmagasiner, la seconde recevant un signal de commande d'écriture (CTL-A ou CTL-B) pour l'écriture dans la bascule du bit sur ladite première entrée et la troisième recevant un signal de commande d'horloge d'écriture (CLK WRL) appliqué aussi à la première électrode de conduction du second transistor (T2).

5. Dispositif selon la revendication 4 caractérisé en ce que le circuit de commande de lecture comprend au moins deux circuits ET, dont les sorties sont connectées à au moins deux transistors émetteurs suiveurs de sortie (T4-C et T4-D), les secondes électrodes de conduction étant connectées à au moins deux circuits de sortie, chacun desdits circuits ET ayant une entrée connectée à la seconde électrode de conduction du troisième transistor de la bascule, et l'autre entrée recevant un signal de commande de lecture (RL-C/RL-D) pour que l'un ou l'autre circuit de sortie détecte l'état de la bascule.

6. Mémoire à accès aléatoire caractérisé en ce qu'elle comporte des bascules selon la revendication 4 ou 5 arrangées en matrice, un circuit de commande d'écriture comportant au moins deux circuits ET étant associés à chaque rangée de bascules, pour provoquer l'écriture des bits d'information simultanément dans au moins deux rangées sélectionnées sous contrôle des signaux de commande d'écriture (CTL A, CTL B) et le signal de commande d'horloge d'écriture (CLK WRL).

7. Mémoire à accès aléatoire caractérisé en ce qu'elle comporte des bascules selon la revendication 5 ou 6 arrangées en matrice, au moins deux lignes de bits (BL-C, BL-D) étant associées à chaque colonne, connectées respectivement aux secondes électrodes de conduction (émetteur) des au moins deux transistors émetteur suiveur pour pouvoir lire simultanément au moins deux rangées de bascules.

## Claims

1. A device for storing and reading a data bit, comprising a write control circuit (D1, D2) responsive to the level of the data bit (IN) to be stored and to a write control signal (WRL) and a latch of the type comprising a first input transistor (T1) having a control electrode (base) connected to the output of the write control circuit, a first conducting electrode (collector) connected to a first supply voltage (V⁺) through a first resistor (R2) and a second conducting electrode (emitter) connected to a reference potential (V$_{REF}$) so that the state of said transistor is controlled by the output signal from the write control circuit, a second transistor (T2) a first conducting electrode (emitter) of which receives the write control signal, and a third transistor (T3) having a control electrode (base) connected to the second conducting electrode (collector) of the second transistor on the one hand and to the first conducting electrode (collector) of the first transistor (T1) on the other hand, a first conducting electrode (emitter) connected to a second supply voltage (V⁻) and the second conducting electrode (collector) connected via a level shifting circuit (D3) to the control electrode of the second transistor on the one hand and to the first supply voltage through a second resistor (R3) on the other hand so that the potential at the second conducting electrode represents the bit stored in the latch, said device being characterized in that it includes :

a read control circuit including a dual-input AND circuit (D3, D5), a first input of which is connected to the second conducting electrode of the third transistor and the second input of which receives a read control signal (RL), and

an output transistor (T4) in an emitter-follower configuration having its control electrode connected to the output of the AND circuit, the first conducting electrode (collector) connected to the first supply voltage (V+) and the second conducting electrode (emitter) connected to a read output circuit (2) which comprises :

a fourth transistor (T5) having a first conducting electrode (collector) connected to the first supply voltage through a third resistor (R5) and a second conducting electrode (emitter) connected to the second conducting electrode (emitter) of the emitter-follower transistor (T4) on the one hand and to the second supply voltage through a fourth resistor (R9) on the other hand,

a fifth transistor (T6) having its control electrode connected to the control electrode of the fourth transistor (T5) and to the first supply voltage through a fifth resistor (R6), its first conducting electrode (collector) connected to said first supply voltage through a sixth resistor (R8) and its second conducting electrode connected to said second supply voltage through a seventh resistor (R10), the resistance of said seventh resistor being greater than the resistance of the fourth resistor,

a first diode (S5) connected between the control electrode and the first conducting electrode of the fourth transistor,

a second diode (S6) connected between the control electrode and the first conducting electrode of the fifth transistor so as to cause either the fourth or the fifth transistor to conduct according to the state of the output emitter-follower transistor provided on the latch, and

a sixth output transistor (T7) having its first conducting electrode (collector) connected to the first supply voltage through an eighth resistor (R7), its second conducting electrode connected to the second supply voltages (V−) and its control electrode connected to the first conducting electrode of the fourth transistor so as to provide on the first conducting electrode, an output signal the value of which will be the complement of the value of the bit stored in the cell.

2. A device according to claim 1 characterized in that the write control circuit comprises a dual-input AND circuit receiving the bit to be stored on a first input and the write control signal on a second input.

3. A random-access storage characterized in that it includes a matrix of latches and write and read circuits according to claim 2, in which :

. each of said latches in each row has the second input of the write control AND circuit connected to a write control line (WRL) to receive, when the row is selected, the write control signal which causes the bit applied to the first input and the write AND circuits of the latches, to be stored into each of said latches,

. each of said latches in each row has the second input of the read control AND circuit connected to a read control line (RL) to receive the read control signal when the row is selected and the second conducting electrode (emitter) of the output emitter-follower transistor connected through a bit line (BL) to a read output circuit common to all the latches of the same order in the various rows.

4. A device according to claim 1 for storing a data bit characterized in that the write control circuit includes at least two AND circuits the outputs of which are connected to the control electrodes of at least two first input transistors (T1-A and T1-B) the first conducting electrodes of which are connected together to the second electrode (collector) of the second transistor, each of said AND circuits having three inputs, the first one of which receiving the bit to be stored, the second one of which receiving a write control signal (CTL-A ou CTL-B) for writting the bit into the latch through said first input and the third one of which receiving a write clock control signal (WR CLK) also applied to the first conducting electrode of said second transistor (T2).

5. A device according to claim 4 characterized in that the read control circuit includes at least two AND circuits the output of which are connected to at least two output emitter-follower transistors (T4-C and T4-D), the second conducting electrodes being connected to at least two output circuits, each of said AND circuits having an input connected to the second conducting electrode of the third transistor in the latch and the second input receiving a read control signal (RL-C/RL-D) to enable either output circuit to detect the state of the latch.

6. A random-access storage characterized in that it includes latches arranged in matrices according to claim 4 or 5, a write control circuit comprising at least two AND circuits associated to each row of latches to cause data bits to be simultaneously written into at least two rows selected as controlled by the write control signals (CTL A, CTL B) and the write clock control signal (CLK WRL).

7. A random-access storage characterized in that it includes latches arranged in matrices according to claim 5 or 6, at least two bit lines (BL-C, BL-D) being associated with each column and respectively connected to the second conducting electrodes (emitter) of said at least two emitter-follower transistors to enable the contents of at least two rows of latches to be simultaneously read out.

**Patentansprüche**

1. Vorrichtung zum Speichern und Lesen eines Informationsbits mit einem Schreibsteuerkreis (D1, D2), der auf das zu speichernde Bit (IN) und auf ein Schreibsteuersignal (WRL) anspricht, und einer Kippschaltung mit einem ersten Eingangstransistor (T1), dessen Steuerelektrode (Base) mit dem Ausgang des Schreibsteuerkreises verbunden ist, während seine erste Leitelektrode (Kollektor) über einen ersten Widerstand (R2) mit einem ersten Versorgungsspannungspegel (V+)

und seine zweite Leitelektrode (Emitter) mit einem Bezugsspannungspegel ($V_{REF}$) verbunden ist, so dass der Zustand des genannten Transistors vom Ausgangssignal des Schreibsteuerkreises gesteuert wird, sowie einem zweiten Transistor (T2), dessen erste Leitelektrode (Emitter) das Schreibsteuersignal empfängt, sowie einen dritten Transistor (T3), bei dem die Steuerelektrode (Base) einerseits mit der zweiten Leitelektrode (Kollektor) des zweiten Transistors und anderseits mit der ersten Leitelektrode (Kollektor) des ersten Transistors (T1) verbunden ist, während eine erste Leitelektrode (Emitter) an einem zweiten Versorgungsspannungspegel ($V^-$) liegt und die zweite Leitelektrode (Kollektor) über einen Pegelverschiebungskreis (D3) einerseits mit der Steuerelektrode des zweiten Transistors und anderseits über einen zweiten Widerstand (R3) mit dem ersten Versorgungsspannungspegel verbunden ist, so dass das Potential an der zweiten Leitelektrode das in der Kippschaltung eingelagerte Bit darstellt, wobei die genannte Vorrichtung weiter durch folgende Elemente gekennzeichnet ist :

einen Lesesteuerkreis, der eine UND-Schaltung mit zwei Eingängen (D4, D5) aufweist, wobei ein erster Eingang mit der zweiten Leitelektrode des dritten Transistors verbunden ist und der zweite Eingang ein Lesesteuersignal (RL) empfängt,

einen Ausgangsfolge-Emittertransistor (T4), dessen Steuerelektrode mit dem Ausgang der UND-Schaltung verbunden ist, während die erste Leitelektrode (Kollektor) am ersten Versorgungspotential ($V^+$) liegt und die zweite Leitelektrode (Emitter) mit dem Leseausgangskreis (2) verbunden ist, zu dem gehören :

ein vierter Transistor (T5), dessen erste Leitelektrode (Kollektor) über einen dritten Widerstand (R5) am ersten Versorgungspotential liegt während die zweite Leitelektrode (Emitter) einerseits mit der zweiten Leitelektrode (Emitter) des Emitter-Folgetransistors (T4) und anderseits über einen vierten Widerstand (R9) mit dem zweiten Versorgungspotential verbunden ist,

ein fünfter Transistor (T6), dessen Steuerelektrode mit der Steuerelektrode des vierten Transistors (T5) und über einen fünften Widerstand (R6) mit dem ersten Versorgungspotential verbunden ist, während seine erste Leitelektrode (Kollektor) über einen sechsten Widerstand (R8) am ersten Versorgungspotential liegt und seine zweite Leitelektrode über einen siebenten Widerstand (R10) mit dem zweiten Versorgungspotential verbunden ist, wobei der Wert dieses siebenten Widerstandes grösser als der Wert des vierten Widerstandes ist,

eine erste, zwischen der Steuerelektrode und der ersten Leitelektrode des vierten Transistors eingeschaltete Diode (S5),

eine zweite, derart zwischen die Steuerelektrode und die erste Leitelektrode des fünften Transistors geschaltete Diode (S6), dass je nach dem Zustand des Emitter-Folgetransistors am Ausgang der Kippschaltung der vierte oder der fünfte Transistor zum Leiten gebracht wird,

ein sechster Ausgangstransistor (T7), dessen erste Leitelektrode (Kollektor) über einen achten Widerstand (R7) am ersten Versorgungspotential liegt während seine zweite Leitelektrode mit dem zweiten Versorgungspotential ($V^-$) und seine Steuerelektrode mit der ersten Leitelektrode des vierten Transistors verbunden ist, um an der ersten Leitelektrode ein Ausgangssignal zu erstellen, dessen Wert das Komplement zum Wert des in der Zelle gespeicherten Bits bildet.

2. Vorrichtung nach Anspruch 1, dadurch gekennzeichnet, dass der Schreibsteuerkreis eine UND-Schaltung mit zwei Eingängen aufweist, wobei der erste Eingang das zu speichernde Bit empfängt und der zweite ein Schreibsteuersignal.

3. Random-Access-Speicher, dadurch gekennzeichnet, dass er eine Kippschaltungsmatrix und Schreib- sowie Lesekreise nach Anspruch 2 aufweist, wobei :

. bei jeder der Kippschaltungen in jeder Reihe der zweite Eingang der Schreibsteuer-UND-Schaltung mit einer Schreibsteuerleitung (WRL) verbunden ist, um bei Anwahl dieser Reihe das Schreibsteuersignal zu empfangen, das in jeder der Kippschaltungen die Einlagerung der Bitreihe hervorruft, die am ersten Eingang der Schreib-UND-Schaltungen der Kippschaltungen anliegt,

. bei jeder der Kippschaltungen in jeder Reihe der zweite Eingang der Lesesteuer-UND-Schaltung mit einer Lesesteuerleitung (RL) verbunden ist, um bei Anwahl dieser Reihe das Lesesteuersignal zu empfangen, und die zweite Leitelektrode (Emitter) des Ausgangs-Emitter-Folgetransistors über eine Bitleitung (BL) mit einem Leseausgangskreis verbunden ist, der allen Kippschaltungen derselben Ordnung in den verschiedenen Reihen gemeinsam ist.

4. Vorrichtung nach Anspruch 1 zum Einspeichern eines Datenbits, dadurch gekennzeichnet, dass der Schreibsteuerkreis zumindest zwei UND-Schaltungen aufweist, deren Ausgänge mit den Steuerelektroden von zumindest zwei ersten Eingangstransistoren (T1-A und T1-B) verbunden sind, deren erste Leitelektroden (Kollektor) miteinander und mit der zweiten Elektrode (Kollektor) des zweiten Transistors verbunden sind, wobei jede der genannten UND-Schaltungen drei Eingänge aufweist, von denen der erste das zu speichernde Bit empfängt, der zweite ein Schreibsteuersignal (CTL-A oder CTL-B), um in der Bit-Kippschaltung im genannten ersten Eingang zu schreiben, und der dritte ein Schreibe-Taktsteuersignal (CLK WRL), das auch an der ersten Leitelektrode des zweiten Transistors (T2) anliegt.

5. Vorrichtung nach Anspruch 4, dadurch gekennzeichnet, dass der Lesesteuerkreis zumindest zwei UND-Schaltungen aufweist, deren Ausgänge mit zumindest zwei Emitter-Ausgangsfolgetransistoren (T4-C und T4-D) verbunden sind, wobei die zweiten Leitelektroden an zumindest zwei Ausgangsschaltungen gekoppelt sind, jede der genannten UND-Schaltungen einen Eingang aufweist, der mit der zweiten Leitelektrode des dritten Transistors der Kippschaltung verbunden ist, und der andere Eingang ein Lesesteuersignal (RL-C/RL-D) empfängt, damit die eine oder die andere Ausgangsschaltung den Zustand der Kippschaltung feststellt.

6. Random-Access-Speicher, dadurch gekennzeichnet, dass er in eine Matrix geordnete Kippschaltungen nach Anspruch 4 oder 5 umfasst, dass jeder Reihe von Kippschaltungen ein Lesesteuerkreis mit zumindest zwei UND-Schaltungen zugeordnet ist, um das gleichzeitige Einlesen der Informationsbits in zumindest zwei, unter Kontrolle der Schreibsteuersignale (CTL A, CTL B) gewählten Reihen hervorzurufen und dass er ein Taktsteuersignal zum Schreiben (CLK WRL) aufweist.

7. Random-Access-Speicher, dadurch gekennzeichnet, dass er in eine Matrix geordnete Kippschaltungen nach Anspruch 5 oder 6 umfasst, wobei jeder Spalte zumindest zwei Bitzeilen (BL-C, BL-D) zugeordnet sind und diese jeweils mit den zweiten Leitelektroden (Emitter) von zumindest zwei Emitter-Folgetransistoren verbunden sind, um gleichzeitig zumindest zwei Kippschaltungsreihen lesen zu können.

0 139 804

CELLULE

FIG
I

# FIG 2

FIG 3

# FIG 4

0 139 804

# FIG 5

# FIG 6

| | 8 CELLU. | 12 CELLU. | | 12 CELLU. | 16 CELLU. | | 16 CELLU. |
|---|---|---|---|---|---|---|---|
| 8 C I R C . C O M R/W | 8 M O T S MATRICE 8 x 8 | 8 M O T S MATRICE 8 x 12 | 8 C I R C . C O M R/W | 8 M O T S MATRICE 8 x 12 | 8 M O T S MATRICE 8 x 16 | 8 C I R C . C O M R/W | 8 M O T S MATRICE 8 x 16 |
| | 8 CIRCUITS SORTIE | 12 CIRCUITS SORTIE | | 12 CIRCUITS SORTIE | 16 CIRCUITS SORTIE | | 16 CIRCUITS SORTIE |